(19) Europäisches Patentamt
European Patent Office
Office européen des brevets

(11) **EP 2 568 494 A2**

(12) **EUROPEAN PATENT APPLICATION**

(43) Date of publication:
**13.03.2013 Bulletin 2013/11**

(51) Int Cl.:
**H01H 83/02** (2006.01)     *G01R 31/02* (2006.01)

(21) Application number: **12180756.4**

(22) Date of filing: **16.08.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (72) Inventor: **Ward, Patrick**<br>**County Galway (IE)** |
| (30) Priority: **06.09.2011 IE 20110389** | (74) Representative: **Boyce, Conor**<br>**FRKelly**<br>**27 Clyde Road**<br>**Ballsbridge**<br>**Dublin 4 (IE)** |
| (71) Applicant: **Atreus Enterprises Limited**<br>**Ballinasloe,**<br>**County Galway (IE)** | |

(54) **Leakage current detector and circuit interrupter**

(57)     An apparatus for detecting a leakage current flowing between at least one supply conductor (L,N) of a multiconductor electricity supply to a load (12) and a non load current carrying electrical conductor (10) nominally insulated from the at least one supply conductor. The apparatus includes a current transformer (CT) having a primary winding (Wp) and a secondary winding (Ws). The primary winding is connected between the non load current carrying conductor and at least one other supply conductor so that a leakage current flowing between the at least one supply conductor and the non load current carrying conductor will flow through the primary winding to the at least one other supply conductor. A an electromechanical relay (PMR) has a set of normally-closed contacts (SW) in series with the electricity supply. Circuitry connecting the secondary winding of the current transformer and the relay is provided such that the relay is actuated by a current induced in the secondary winding by a leakage current meeting certain criteria as to magnitude and/or duration.

Fig. 4

EP 2 568 494 A2

**Description**

This invention relates to a leakage current detector (LCD).

Over recent years there has been a dramatic growth in the use of leakage current detectors fitted on mains plugs, extension cords and appliances. These devices now form a family of products including but not limited to the following:

  LCDI - leakage current detection interrupter.
  ALCI - appliance leakage current circuit interrupter.
  IDCI - immersion detection circuit interrupter.

Although the applications are slightly different, in all cases the device is arranged to detect the presence of a dangerous or unwanted leakage current flowing from a load current carrying electrical conductor (e.g. mains supply live or neutral) to a non load current carrying electrical conductor nominally insulated from the load current carrying conductor. The non load current carrying conductor may be a shield, screen or wire, or it may be an electrically conductive chassis, housing or other component containing or associated with electrical equipment, for example, the chassis or body of an electric vehicle. The non load current carrying conductor will be referred to herein generically as conductor K.

In the accompanying drawings a screen 10 incorporated in an AC mains supply cable is the non load current carrying conductor K, but the embodiments, and the invention in general, is applicable to any non load current carrying conductor.

It should also be noted that LCDI type products can also detect arc fault currents in accordance with UL1699, so their application is not strictly limited to leakage current detection.

For convenience, the above devices are referred to in this document simply as leakage current detectors (LCDs).

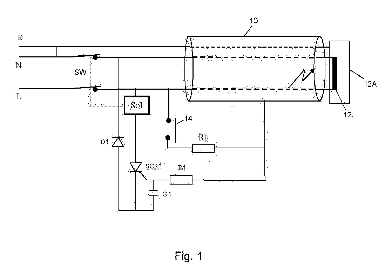

Figure 1 is an example of a very simple leakage current detector.

In the arrangement of Figure 1, an electric cable comprises AC mains supply conductors L (live), N (neutral) and E (earth) surrounded by a conductive screen 10 incorporated within the cable. The cable supplies a load 12 which may be contained within an earthed housing, casing or other conductive exterior component 12A surrounding the load 12. In some cables the individual mains conductors are surrounded by individual screens. Both arrangements are well known and common practice in the field of leakage current detection. The leakage current detector circuit comprises a solenoid SOL, a silicon controlled rectifier SCR1, a diode D1, a resistor R1 and a capacitor C1 connected as shown. The solenoid SOL is coupled to a set of normally closed contacts SW in the mains live L and neutral N conductors, the solenoid SOL and contacts SW being configured as an electromechanical relay. For the purposes of the present specification an electromechanical relay is an electrical switch with mechanical contacts which are operated by a magnetic field produced by current flowing in a coil, usually a solenoid.

In Figure 1 the solenoid SOL may comprise a plunger positioned within a coil and when a current of sufficient magnitude flows through the coil the plunger is moved from a first position to a second position with sufficient force to cause automatic opening of the contacts to which it is coupled. The force required to open the contacts is produced solely by the current flowing through the solenoid coil, and such automatic opening of the contacts is referred to as actuation.

In the event of an insulation breakdown between the live conductor L and the screen 10, indicated by the zigzag arrow, a fault current will flow via R1 into the gate of the SCR and back to the supply N via diode D1. When this current exceeds a certain threshold the SCR1 will turn on and connect the solenoid SOL across the live L and neutral N of the mains supply, thereby activating the solenoid SOL and causing the contacts SW to open and disconnect the supply from the load 12. Any leakage current that exceeds the threshold is deemed to be a fault current arising from a breakdown in insulation. Such fault currents could result in an electrical fire if not detected and terminated within a certain period of time. Thus the primary role of a leakage current detector is to detect a leakage current above a certain threshold and to terminate the flow of such current within a specified period of time.

The prior art circuit typically includes a test circuit comprising a manually closable switch 14 and series resistor Rt. Pressing the switch 14 simulates a leakage current from the live conductor to the screen 10.

Figure 1 is configured to detect a leakage current between the live conductor L and the screen 10, the screen being the non load current carrying electrical conductor K. However, the circuit could alternatively detect a leakage current between the live conductor L and the load housing 12A, in which case the resistor R1 would be connected to the housing 12A rather than to the screen 10.

Although the arrangement of Figure 1 is a simplified example, and is offered merely as an example to explain the principle of operation of an LCD and is not meant to imply that such a circuit would be of practical use for such an application, it does serve to demonstrate the basic principle of operation of leakage current detection. More sophisticated circuits use a current transformer or integrated circuit or opto coupler or other elaborate circuitry or means to carry out the functions of detection of the leakage current and disconnection of the supply within specified limits of fault current and time. Some examples of the prior art are shown in United States Patent Specifications 6122155, 7136266, 7359167, 6292337 and 7423854.

However, the known prior art suffers from problems such as complexity, large component count, large amount of circuitry, and relatively high cost. Furthermore, many devices on the market suffer from problems of nuisance tripping. It is generally assumed that this is due to voltage or current surges on the mains supply impacting on the LCD circuitry, and this is certainly one cause of nuisance tripping. However, it should be noted that in screened cable there can be a relatively high degree of capacitive coupling between the screen and load current carrying conductors, and this provides a medium for the flow of AC frequency components between the conductors and the screen. In effect, the screen itself can be a conduit for unintended leakage currents. Because this coupling is capacitive, it will be more conducive to leakage current flow at higher frequencies than lower frequencies. Currents with higher frequency components generally present minimal fire risk in comparison to currents at power frequency (mains supply frequency) and therefore should be ignored, but they can be inadvertently detected and give rise to nuisance tripping.

Many of the above problems are well known to those versed in the art of residual current devices (RCDs), which have been in use worldwide for about fifty years. RCDs can be divided into two broad categories: voltage dependent (VD) and voltage independent (VI). These are sometimes referred to as electronic and electromechanical types respectively. Voltage dependent RCDs use energy from the mains supply to carry out the functions of detection of a residual current and tripping of the RCD. Voltage independent RCDs use energy derived from the residual current alone to carry out the functions of detection and tripping. (For more detailed information on RCD technology, see the article "Demystifying RCDs" at www.westernautomation.com )

Various approaches to the detection of leakage currents have attempted to use conventional VD RCD techniques. However, as used to date in the area of leakage current detection, these techniques generally carry over from the RCD industry to the LCD industry many of the problems of complexity, size, cost and reliability without any significant mitigation of these problems.

Based on existing regulations, most leakage current detectors are required to operate at current levels down to 5mA. VD RCD technology has been shown to operate at this level for detection of residual currents, and attempts have been made to apply such technology to leakage current detection. However, such techniques usually involve taking the output from a current transformer and amplifying it to a usable value for the purpose of detection of the leakage current, comparing the amplified signal with a reference, and actuating an operating means when the leakage current exceeds a predetermined value. Conventional VD RCD technology operating at levels as low as 5mA tends to be highly prone to nuisance tripping due to factors such as the presence of high frequency components, surge currents, input offset levels on the amplifying circuitry, etc.

Although, as stated, attempts have been made to use VD RCD technology for leakage current detection, we are not aware of any successful use of VI RCD technology for leakage current detection, at least at levels as low as 5mA. The main reason for this is that VI RCDs rely entirely on the energy of a residual current for their operation, and the available energy is proportional to the residual current flow. In practice, most VI RCDs operate at currents of 30mA or higher whereas LCDs are required to operate down to 5mA, which generally will not provide sufficient energy to operate a VI RCD.

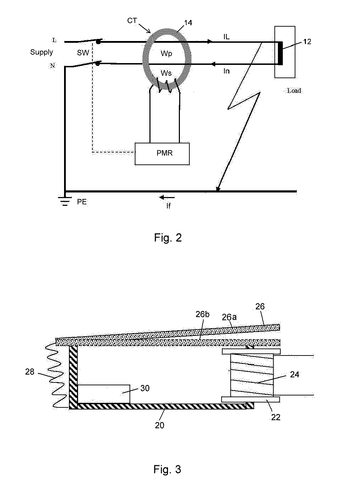

Figure 2 is a circuit diagram of a typical VI RCD.

In the arrangement of Figure 2, AC mains L and N supply conductors are passed through a current transformer CT en route to a load 12. Mechanically latched contacts SW are normally held in the closed position to provide the supply to the load. The CT comprises a toroidal core 14 of ferromagnetic material such as nickel iron or nanocrystaline material through which pass the load conductors L, N forming a primary winding Wp of the CT (the term "winding" is used in accordance with conventional terminology, even though the conductors L, N pass directly through the core 14 rather than being wound on it). A winding Ws forms a secondary winding of the CT. When a residual current flows in the primary circuit it will induce a corresponding current into the secondary winding Ws which is connected across the coil of a permanent magnet relay PMR.

A PMR is a particular type of electromechanical relay in which a movable component (actuator) is resiliently biased, e.g. by a spring, towards a first position against the attracting force of a permanent magnet which acts in the opposite direction to the resilient bias and whose greater force normally holds the actuator in a second position. The actuator is released and moved by the resilient bias to the first position when the magnetic holding force is sufficiently weakened due to a current of a certain magnitude and polarity flowing in a coil within the PMR. The movement of the actuator to the first position causes automatic opening of electrical contacts which are mechanically coupled to the actuator (the opening of the contacts is referred to as actuation of the PMR).

The PMR uses the attracting force of the permanent magnet to hold the actuator in the second position against the counter force of the resilient biasing means, and this attracting force has to be just partially reduced to achieve actuation. Thus with a relatively small amount of current flow through the PMR coil, actuation of electrical contacts can be achieved by releasing the stored energy, in contrast to a simple solenoid where actuation depends entirely on the current flow thought its coil.

In the example shown in Figure 3, the PMR comprises a yoke 20 on which is fitted a bobbin 22. A solenoid coil 24 is wound on the bobbin 22. A moving armature 26 is pivoted at one end (the LHS in Figure 3) and biased towards an open position 26a by an opening spring 28. A permanent magnet 30 is fitted on the yoke 20 and induces a magnetic flux into the yoke. When the free end of the armature 26 (the RHS in Figure 3) is moved - manually or otherwise) - into a closed position 26b in contact with the yoke, a closed magnetic path is formed and the flux flows around the closed path formed by the yoke 20 and the armature 26. This magnetic flux holds the armature in this closed position against the bias of the opening spring 28.

When a current of a certain polarity is caused to flow in the coil 24, an electromagnetic field will be established which will produce a flux in opposition to that of the permanent magnet such that the holding force on the armature will be reduced. When the coil current reaches a certain level, the holding magnetic force will be sufficiently reduced so as to release the armature and allow it to move to the open position under the action of the spring 28. The actuator 26 is mechanically coupled (not shown) to a set of normally closed contacts SW in the mains live L and neutral N conductors. The movement of the armature 26 to the open position 26a is used to open these contacts, disconnecting the load 12 from the mains supply. Referring back to Figure 2, under normal conditions the current in the live conductor $I_L$ equals the current in the neutral conductor In. Under a residual fault condition an additional current $I_f$ flows to earth. This current also flows in the live conductor L but returns to the supply via the earth return path with the result that the CT now sees $I_f$ as a differential or residual current. When this differential current exceeds the rated residual operating current I∆n of the RCD, the PMR will be activated and cause the contacts SW to open and thereby disconnect the load.

The PMR depicted in Figures 2 and 3 is essentially a current operated device. This is because the PMR coil contains a relatively small number of turns such that the coil impedance will be very low. This in turn facilitates maximum current transfer from the CT to the PMR coil. A typical PMR as used in a 30mA VI RCD will require about 100μVA of power for activation. For a 30mA residual current operating threshold the corresponding voltage will be about 3mV, so clearly the current is the dominant factor in the successful operation of the PMR.

A critical requirement of the VI RCD arrangement is to extract sufficient energy at I∆n so as to operate the PMR. If there is insufficient energy available at for example, 30mA, one or more of the following actions may be taken to enable the device to operate effectively at the required level:

    1. Use a lower energy (i.e. more sensitive) PMR.
    2. Use a higher energy core for the CT.
    3. Use multiple turns in the primary winding.

The use of a more sensitive PMR will involve extra cost, but also make the device more prone to nuisance tripping.

The use of a higher energy core will involve additional cost, and because it is usually larger it will also create additional space requirements.

The use of multiple primary turns will involve additional space requirements because the insulated load conductors will be of relatively large diameter, typically >4mm. Furthermore, this option is limited by the number of turns that can be wrapped around the CT core and is generally limited to 2 - 3 primary turns.

Given that most LCDs are required to operate at a leakage current of at least 5mA, it is understandable why VI RCD technology has to date been deemed unsuitable for this application.

It is an object of the invention to provide a leakage current detector (LCD) which overcomes or mitigates at least some of the problems associated with RCD techniques.

Accordingly, the present invention provides an apparatus for detecting a leakage current flowing between at least one supply conductor of a multi-conductor electricity supply to a load and a non load current carrying electrical conductor nominally insulated from the at least one supply conductor, the apparatus including:

    (a) a current transformer having a primary winding and a secondary winding, the primary winding being connected between the non load current carrying conductor and at least one other supply conductor so that a leakage current flowing between the at least one supply conductor and the non load current carrying conductor will flow through the primary winding to the at least one other supply conductor,
    (b) an electromechanical relay having a set of normally-closed contacts in series with the electricity supply, and
    (c) circuit means connecting the secondary winding of the current transformer and the relay such that the relay is actuated by a current induced in the secondary winding by a leakage current meeting certain criteria as to magnitude and/or duration.

In one embodiment the current induced in the secondary winding flows directly though the relay coil to actuate the relay.

In another embodiment the current induced in the secondary winding charges up a capacitor which turns on an electronic switch when the voltage on the capacitor reaches a certain level, turning on the electronic switch allowing the capacitor to discharge through the relay coil to actuate the relay.

Preferably the secondary winding forms part of a tuned circuit having a resonant frequency at or near the supply frequency.

Most preferably the electromechanical relay is a permanent magnet relay.

The non load current carrying conductor may be a screen incorporated in a multi-conductor electricity supply cable supplying the load, the screen surrounding at least one supply conductor of the cable.

Alternatively the non load current carrying conductor may be an electrically conductive chassis, housing or other component containing or associated with electrical equipment.

Preferably the primary winding is connected between the non load current carrying conductor and each of two supply conductors for detecting a leakage current flowing between either one of the supply conductors to the non load current carrying electrical conductor.

In a preferred embodiment of the invention a plurality of the supply conductors form a further primary winding for the current transformer, whereby the apparatus also acts as a residual current device.

The invention facilitates the use of VI RCD technology in an LCD able to operate down to at least 5mA.

Embodiments of the invention will now be described, by way of example, with reference to the accompanying drawings, in which:

Figure 1 is a circuit diagram illustrating prior art techniques for leakage current detection.

Figure 2 is a circuit diagram of a prior art voltage independent residual current device (VI RCD).

Figure 3 is a diagram of a permanent magnet relay (PMR) of a kind which may be used in the prior art VI RCD as well as in the embodiments of the invention.

Figure 4 is a circuit diagram of a first embodiment of the invention.

Figures 5a and 5b are graphs illustrating the operation of Figure 4.

Figures 6a, 6b, 7 and 8 are further embodiments of the invention.

In the various figures the same references have been used for the same or equivalent components.

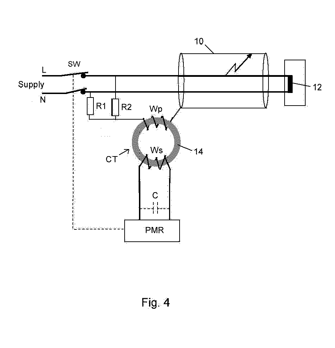

Referring to Figure 4, a leakage current detector according to a first embodiment of the invention comprises a current transformer CT having a primary winding Wp and a secondary winding Ws wound on a ferromagnetic core 14. As compared to an RCD, the CT core 14 does not encircle the load conductors L, N. The primary winding Wp comprises a single wire with multiple turns, one end of the primary winding being connected to the screen 10 and the other end to the supply conductors N, L via respective resistors R1 and R2. A continuous current will flow through R1 and R2, but this can be kept to an acceptably low level.

In the event of an insulation breakdown between the supply live conductor L and the screen 10, a leakage current will flow from supply live L to the screen, through the primary winding Wp, and back to the supply neutral N via resistor R1. This leakage current flowing in the primary winding Wp will induce a current in the secondary winding Ws which flows through the PMR coil. If the secondary current induced in Ws exceeds a certain threshold, corresponding to a certain level of primary leakage current, the PMR will be actuated and the contacts SW opened, provided the leakage current persists beyond any inherent delay in the operation of the relay.

The circuit can be set to respond to a selected level IΔn of leakage current flowing to the screen 10. The operating threshold can be calibrated by a suitable choice of resistors R1 and R2 together with the number of turns in winding Wp. It should be noted that screen 10 is not intended to carry a load current, and therefore the wire used in primary winding Wp may be of very small diameter, e.g. 0.1mm, which will be 40 - 50 times less than the diameter of a single load conductor. Given that Wp is now a single conductor of nominally 0.1mm diameter, it becomes possible to wind multiple turns around the CT core 14, e.g. 100 turns. Any given leakage current flowing via Wp to the screen 10 will be transformed within the CT so as to step up the primary current to a substantially larger secondary current by the ratio of Wp:Ws and thereby produce a much larger value of ampere turns for operation of the PMR. For example, if the leakage current was 5mA, this would translate into 500mAT for a 100-turn Wp in the CT. The corresponding energy is used to operate the leakage current detector at any desired value of IΔn, e.g. 5mA. However, it follows that the circuit could readily be adapted for operation at substantially lower leakage current levels. For example, if Wp comprised 1000 turns the CT would produce 500mAT for a leakage current of just 0.5mA, making leakage current detection at such low levels feasible. By leveraging the leakage current energy, the PMR need not be a sensitive type, thereby reducing its cost. The CT core size can be substantially smaller, and given that the windings in the CT will comprise very small diameter wire, the wound core would also be smaller. The circuit of Figure 4 would not even require a printed circuit board assembly, which would make the fully assembled LCD more compact, cheaper and far more reliable than existing LCDs.

The energy made available to operate the PMR can be further harnessed by connecting a capacitor across the secondary winding Ws. This is shown in dotted lines as C in Figure 4. The winding Ws, the capacitor C and the inductance L of the PMR are arranged as a tuned circuit with a resonant frequency Fo which is at or near the mains supply frequency and is derived from the formula:

$$Fo = 1/(2\pi\sqrt{LC})$$

For a 60Hz mains supply, Fo will be made as close to 60Hz as possible, and this will ensure maximum energy transfer from the primary to the secondary circuit for leakage currents at this frequency.

For the purpose of demonstrating this effect, the current transformer CT, the capacitor C and the relay PMR in the arrangement of Figure 4 were selected so as to produce a resonant frequency of about 60Hz with the intention of optimizing the CT output to the PMR to be made to peak at around this frequency. For a fixed value of current in Wp, the output across Ws was measured, with the peak value being taken as 100% of the available output.

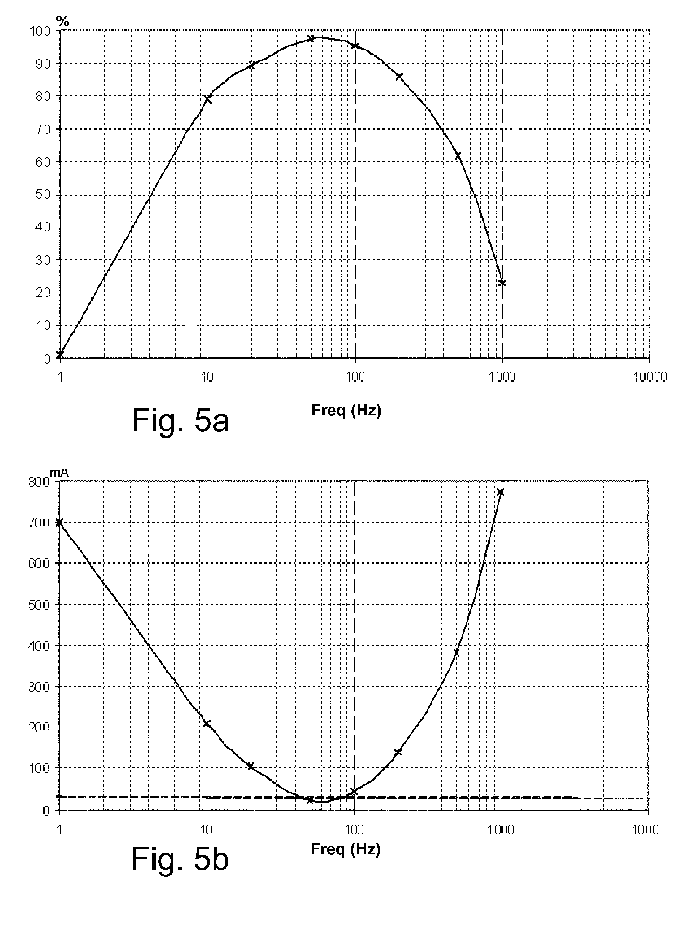

Figure 5a shows the resultant output as a percentage of the peak output plotted over the range 0 to 1000Hz. Values in excess of about 90% in Figure 5a correspond to the operation of the PMR. It can be seen that the output peaked at about 60Hz, with the output falling off rapidly on either side of this value.

There is a corresponding relationship between the tuned circuit response of Figure 4a and the leakage current required to operate the PMR as shown in Figure 5b.

It can be seen that within the range 50 to 80 Hz, the current required to operate the PMR is at about 30mA, but at frequencies outside this range the current required to operate the PMR is much higher. As a result, a circuit comprising the CT, PMR and a capacitor can be made to maximize the available energy around a specific resonant frequency, with reduced output at other frequencies. This not only maximizes available energy at a certain frequency for a given selection of components, but also gives the LCD a very high level of immunity to nuisance tripping that might be caused by high frequency components flowing in the mains circuit.

It should also be noted that the circuit of Figure 4 operates independently of the mains supply voltage, and can therefore operate at any supply voltage level which can produce the requisite leakage current for operation. In addition, it can be seen that the use of a CT enables the detecting and actuating circuitry to be isolated from the mains supply, and thereby substantially reduces the risk of damage to these key components that might arise from mains borne influences such as voltage surges, etc.

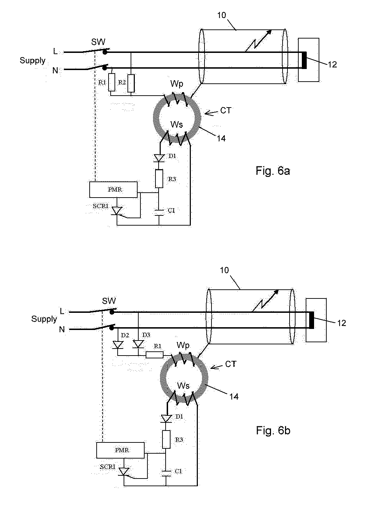

Another embodiment of the invention is shown in Figure 6a. In this embodiment the CT output from the secondary winding Ws is used to charge a capacitor C1 via a diode D1 and a resistor R3. When the voltage on C1 reaches a certain threshold, an SCR1 will turn on and cause C1 to discharge via the PMR coil and cause the contacts SW to open. The CT core 14 and windings Wp, Ws can be mutually selected to enable satisfactory operation at a desired leakage current threshold, IΔn. A bleed resistor (not shown) may be connected across C1 to discharge C1 at a rate which ensures that if the leakage current is below a certain level C1 will not acquire sufficient charge to turn on SCR1.

This method of operation can be assisted by using diodes to replace R1 and R2, as shown in Figure 6b, where the diodes D2 and D3 provide the conduction path for the leakage current, and resistor R1 is used to calibrate the operating threshold of the LCD.

The embodiments of Figures 6a and 6b could also include a tuning capacitor C as shown in Figure 4. However, as the existing capacitor C1 acts to some extent as a filter, the tuning behavior is not so important in these circuits.

The maximum leakage current that can flow in the non load carrying conductor K (the screen 10 in the embodiments) for any given supply voltage will arise when there is a direct connection between conductor K and a load conductor. It should be noted that in the embodiments of Figures 4 and 6a, this maximum leakage current is limited and therefore determined by resistors R1 and R2. In the embodiment of Figure 6b, the corresponding maximum leakage current is determined by resistor R1. Thus resistors R1 or R2 in the embodiments of Figures 4 & 6a, or resistor R1 in the embodiment of Figure 6b can be selected with the intention of limiting the maximum leakage current that can flow for a given supply voltage.

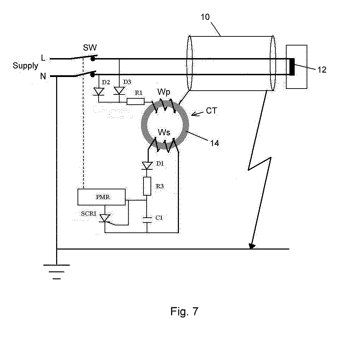

Figure 7 shows the LCD circuit within the context of a conventional TN system wherein the neutral conductor N is connected to earth and a protective earth conductor is distributed within the system. The screen 10 (non load current carrying conductor K) is normally floating, with no direct connection to the supply conductors or earth. It can be seen from Figure 7 that in the event of the screen 10 being inadvertently connected to earth, a leakage current will flow from supply Live to Neutral via Wp, resulting in operation of the LCD when this current exceeds the operating threshold of the LCD. Thus the LCD can also detect an unwanted connection of the screen 10 (conductor K) to earth.

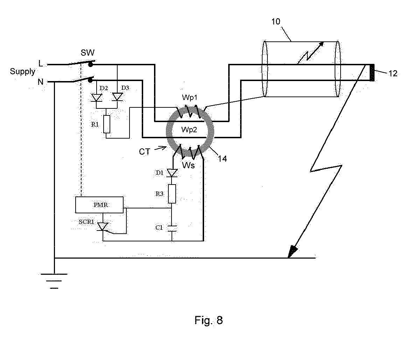

The embodiments of Figures 4, 6a and 6b demonstrate how VI RCD techniques can be adapted to facilitate the production of a VI LCD. Whilst the prospective leakage current flow can be limited as previously described, the circuit does not provide any limit to the prospective residual current that could flow from live to earth. As previously stated, the LCD part can be made to operate at any convenient level below the 5mA threshold required of the relevant LCD product standards, but the LCD will not provide protection against a residual current flowing as indicated in Figure 2. It was demonstrated by Figure 2 how the PMR and CT could be used to operate as an RCD, for example at 30mA. In a further embodiment of the invention, an RCD function may advantageously be included within the LCD as demonstrated by the arrangement of Figure 8.

In the arrangement of Figure 8, the supply conductors L, N are also passed through the aperture of the CT core 14 to form a second primary winding Wp2, the original primary winding Wp now being designated Wp1. The leakage current detector circuit operates at a relatively low current level as previously described. However, by additionally passing the load conductors L, N at least once through the CT core, an RCD function can be implemented by using the CT to produce sufficient output to operate the PMR for a residual current of a certain magnitude flowing from the live conductor L to earth, as represented by the zigzag line on the far right of Figure 8. By optimizing the number of turns of Wp1 and Wp2, the LCD can provide protection against both leakage currents and residual currents within specific limits.

The embodiments of the invention described above can use a PMR of the form shown in Figure 3 or a PMR of the form disclosed in US Patent Specification No. 6975191, or any other suitable form of PMR.

The embodiments of the invention described herein provide a novel and highly effective means of detecting leakage currents which mitigates at least some of the problems of current designs. They operate on the principle of leveraging or amplifying the leakage current to provide optimum energy for operating a voltage independent leakage current detector. A particularly advantageous embodiment also has means for detection of residual currents by voltage independent means.

The invention is not limited to the embodiments described herein which may be modified or varied without departing from the scope of the invention.

**Claims**

1.  An apparatus for detecting a leakage current flowing between at least one supply conductor (L,N) of a multi-conductor electricity supply to a load (12) and a non load current carrying electrical conductor (10) nominally insulated from the at least one supply conductor, the apparatus including:

    (a) a current transformer (CT) having a primary winding (Wp) and a secondary winding (Ws), the primary winding being connected between the non load current carrying conductor and at least one other supply conductor so that a leakage current flowing between the at least one supply conductor and the non load current carrying conductor will flow through the primary winding to the at least one other supply conductor,
    (b) an electromechanical relay (PMR) having a set of normally-closed contacts (SW) in series with the electricity supply, and
    (c) circuit means connecting the secondary winding of the current transformer and the relay such that the relay is actuated by a current induced in the secondary winding by a leakage current meeting certain criteria as to magnitude and/or duration.

2.  An apparatus as claimed in claim 1 wherein the current induced in the secondary winding flows directly though the relay coil to actuate the relay.

3.  An apparatus as claimed in claim 1 wherein the current induced in the secondary winding charges up a capacitor (C1) which turns on an electronic switch (SCR1) when the voltage on the capacitor reaches a certain level, turning on the electronic switch allowing the capacitor to discharge through the relay coil to actuate the relay.

4.  An apparatus as claimed in claim 1 wherein the secondary winding forms part of a tuned circuit (PMR, C) having a resonant frequency at or near the supply frequency.

5.  An apparatus as claimed in claim 1 wherein the electromechanical relay is a permanent magnet relay (PMR).

6.  An apparatus as claimed in claim 1 wherein the non load current carrying conductor is a screen (10) incorporated in a multi-conductor electricity supply cable supplying the load, the screen surrounding at least one supply conductor of the cable.

7.  An apparatus as claimed in claim 1 wherein the non load current carrying conductor may be an electrically conductive chassis, housing or other component containing or associated with electrical equipment.

8.  An apparatus as claimed in claim 1 wherein the primary winding is connected between the non load current carrying conductor and each of two supply conductors for detecting a leakage current flowing between either one of the supply conductors to the non load current carrying electrical conductor.

9.  An apparatus as claimed in claim 1 wherein a plurality of the supply conductors form a further primary winding (Wp2) for the current transformer, whereby the apparatus also acts as a residual current device.

Fig. 1

Fig. 2

Fig. 3

Fig. 4

Fig. 5a     Freq (Hz)

Fig. 5b     Freq (Hz)

Fig. 6a

Fig. 6b

Fig. 7

Fig. 8

**EP 2 568 494 A2**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6122155 A
- US 7136266 B
- US 7359167 B
- US 6292337 B
- US 7423854 B
- US 6975191 B